Europäisches Patentamt

European Patent Office

Office européen des brevets

(11) Veröffentlichungsnummer: **0 591 759 A2**

## (12) EUROPÄISCHE PATENTANMELDUNG

(21) Anmeldenummer: **93115222.7**

(22) Anmeldetag: **22.09.93**

(51) Int. Cl.5: **C09D 4/00**, G03F 7/027

(30) Priorität: **09.10.92 DE 4234072**

(43) Veröffentlichungstag der Anmeldung:
**13.04.94 Patentblatt 94/15**

(84) Benannte Vertragsstaaten:
**AT BE CH DE ES FR GB IT LI NL SE**

(71) Anmelder: **MORTON INTERNATIONAL, INC.**
**100 North Riverside Plaza**
**Randolph Street at the River**
**Chicago Illinois 60606-1596(US)**

(72) Erfinder: **Schütze, Gerald, Dr.**
**Ubierstrasse 13**
**D-6238 Hochheim(DE)**
Erfinder: **Lingnau, Jürgen, Dr.**
**Karolingerstrasse 10**
**D-6500 Mainz-Laubenheim(DE)**

(74) Vertreter: **Weber, Dieter, Dr. et al**
**Weber, Dieter, Dr.,**
**Seiffert, Klaus, Dipl.-Phys.,**
**Lieke, Winfried, Dr.**
**Postfach 61 45**
**D-65051 Wiesbaden (DE)**

(54) **Durch Strahlung polymerisierbares Gemisch und Verfahren zur Herstellung einer Lötstoppmaske.**

(57) Es wird ein durch Strahlung polymerisierbares Gemisch beschrieben, das für die Herstellung von Lötstopp-masken geeignet ist und das
  a) eine radiaklisch polymerisierbare Verbindung,
  b) ein Carboxylgruppen enthaltendes Bindemittel,
  c) einen Photopolymerisationsinitiator und
  d) eine cycloaliphatische Epoxyverbindung mit mindestens zwei Epoxygruppen
enthält.
Das Gemisch weist eine bessere Lagerfähigkeit in Lösung und als feste Schicht auf einer Leiterplatte auf.

EP 0 591 759 A2

Die Erfindung betrifft ein durch Strahlung polymerisierbares Gemisch, das zur Herstellung von Lötstoppmasken verwendet wird und das als wesentliche Bestandteile

a) eine Verbindung mit mindestens einer endständigen ethylenisch ungesättigten Gruppe, die durch radikalisch initiierte Additionskettenpolymerisation ein vernetztes Polymerisat zu bilden vermag,

b) ein wasserunlösliches, in wäßrig-alkalischen Lösungen lösliches, Carboxylgruppen enthaltendes polymeres Bindemittel,

c) einen durch Strahlung aktivierbaren Polymerisationsinitiator oder eine Polymerisationsinitiatorkombination und

d) eine Verbindung, die mindestens zwei Epoxygruppen aufweist,

enthält.

Gemische dieser Zusammensetzung sind aus der EP-A 418 733 bekannt und in der älteren deutschen Patentanmeldung P 41 42 735.1 beschrieben. Diese Gemische enthalten als Epoxyverbindungen (d) im wesentlichen Bisglycidylether von zwei- oder dreiwertigen aliphatischen Alkoholen oder Phenolen. Die bekannten Gemische haben den Nachteil, daß eine Korrosion von Metallflächen, mit denen sie in direktem Kontakt stehen, bei Einwirken von Feuchtklima möglich ist. Auch ist die Lagerfähigkeit der Gemische im gelösten Zustand sowie in Form von lichtempfindlichen Schichten auf einer strukturierten Leiterplatte in vielen Fällen unzureichend. Dies wirkt sich dahin aus, daß die belichtete Lötstoppmaske nicht mehr sicher und vollständig entwickelt werden kann oder daß die metallischen Leiterbahnen korrodiert werden können.

Es wurde nun gefunden, daß diese Nachteile durch ionische Verunreinigungen, wie Halogenidionen, verursacht werden. Es wurde weiter gefunden, daß die bisher eingesetzten Epoxyverbindungen schon aufgrund ihrer Herstellung aus Epichlorhydrin und z.B. Bisphenol A Halogenidionen enthalten. Bei der Umsetzung von Epichlorhydrin in Gegenwart von Basen wird HCl abgespalten, das dem Umsetzungsprodukt in Form von Chloridionen anhaftet.

In der EP-A 255 989 werden Negativ-Photoresistmaterialien beschrieben, die alkalilösliche Polyphenole, Epoxyverbindungen und einen kationischen Photoinitiator für die Vernetzung der Epoxygruppen enthalten. Als Epoxyverbindungen werden aromatische, aliphatische und cycloaliphatische Verbindungen eingesetzt. Die bildmäßige Härtung erfolgt hier im wesentlichen durch photoinduzierte Vernetzung der Epoxygruppen, kann aber auch thermisch vervollständigt werden.

In der EP-A 502 382 werden lichtempfindliche, zur Herstellung von Lötstoppmasken geeignete Gemische beschrieben, die alkalilösliche Phenolharze, Epoxyharze und photoaktivierbare Härtungskatalysatoren für die Epoxygrupen enthalten. Auch hier kann die bildmäßige Lichthärtung durch nachfolgendes Erwärmen vervollständigt werden.

Aufgabe der Erfindung war es, ein für die Herstellung von Lötstoppmasken geeignetes strahlungsempfindliches Gemisch der eingangs beschriebenen Gattung vorzuschlagen, das sich von dem bekannten Gemisch durch eine bessere Lagerfähigkeit im gelösten und im festen Zustand und durch eine bessere Haftung an Metalloberflächen bei der bestimmungsgemäßen Verwendung unterscheidet.

Erfindungsgemäß wird ein durch Strahlung polymerisierbares Gemisch vorgeschlagen, das

a) eine Verbindung mit mindestens einer endständigen ethylenisch ungesättigten Gruppe, die durch radikalisch initiierte Additionskettenpolymerisation ein vernetztes Polymerisat zu bilden vermag,

b) ein wasserunlösliches, in wäßrig-alkalischen Lösungen lösliches, Carboxylgruppen enthaltendes polymeres Bindemittel,

c) einen durch Strahlung aktivierbaren Polymerisationsinitiator oder eine Polymerisationsinitiatorkombination und

d) eine Verbindung mit mindestens zwei Epoxygruppen

enthält.

Das erfindungsgemäße Gemisch ist dadurch gekennzeichnet, daß die Epoxyverbindung eine cycloaliphatische Epoxyverbindung ist.

Erfindungsgemäß wird ferner ein Verfahren zur Herstellung einer Lötstoppmaske vorgeschlagen, das dadurch gekennzeichnet ist, daß man eine Lösung oder Dispersion eines Gemisches gemäß einem der Ansprüche 1 bis 7 auf die Oberfläche einer strukturierten Leiterplatte aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Maske auf erhöhte Temperatur erwärmt.

Als cycloaliphatische Epoxyverbindungen sind grundsätzlich alle Verbindungen geeignet, die mindestens einen cycloaliphatischen Ring und mindestens eine Epoxygruppe enthalten, wobei die Epoxygruppen nicht durch Chlorwasserstoffabspaltung aus einem Chlorhydrin entstanden sind. Insbesondere Verbindungen mit Glycidylgruppen sind nicht geeignet.

Bevorzugt werden Verbindungen, die Epoxygruppen an einem cycloaliphatischen Ring enthalten, also Verbindungen, die durch Epoxydation von Cycloalkenen entstanden sind. An einen Cycloalkylring können eine oder zwei Oxiranringe angeschlossen sein. Die Epoxygruppe kann auch Bestandteil eines aliphatischen Substituenten am Cycloalkylrest sein, d.h. dieser Substituent kann eine epoxydierte Alkenylgruppe sein, die vorzugsweise 2 bis 6, besonders bevorzugt 2 bis 4 Kohlenstoffatome enthält.

Die Verbindung kann einen oder mehrere Cycloalkylringe enthalten, die am allgemeinen 4 bis 8, vorzugsweise 5 bis 7 und insbesondere 5 oder 6 Ringglieder haben. Sie kann außer den cycloaliphatischen und Epoxyalkylgruppen weitere aliphatische Substituenten, wie Alkylgruppen, Alkylengruppen, Alkoxygruppen und/oder Carbonsäureestergruppen enthalten. Auch können gesättigte oder teilweise ungesättigte Ringe im Molekül enthalten sein, die 1 oder 2 Heteroatome, wie O, S oder N als Ringglieder enthalten. Solche Ringe können als Substituenten, als anellierte Ringe oder in spiranartiger Verknüpfung vorliegen. Die Verbindung enthält mindestens 2, vorzugsweise 2 bis 4 Epoxygruppen im Molekül.

Die Epoxyverbindungen werden im allgemeinen durch Epoxydation, insbesondere mit Persäuren, z.B. Peressigsäure, aus Cycloolefinen oder Alkenylcycloalkanen hergestellt. Die Herstellung ist u.a. in POLYMER ENCYCLOPEDIA, Band 6, S. 336 ff., beschrieben.

Das Gemisch enthält bevorzugt noch einen Härter oder Additionsinitiator (e) für Epoxygruppen. Der Härter ist bevorzugt eine Stickstoffbase, z.B. Triethylamin, 1,4-Diazabicyclo[2.2.2.]octan (Dabco), höher alkylierte Mono-, Di- und Triamine auf aliphatischer Basis, ferner aliphatisch-aromatische Amine wie z.B. Dimethylanilin. Die tertiären, insbesondere aliphatischen Amine werden bevorzugt. Ganz besonders bevorzugt wird das Diazabicyclooctan. Die Menge der Base liegt im allgemeinen zwischen 0 und 1,5, vorzugsweise zwischen 0,2 und 1,0 Gew.-%.

Als polymerisierbare Verbindungen (a) werden im allgemeinen Ester der Acryl- oder Methacrylsäure mit mehrwertigen, vorzugsweise primären, Alkoholen verwendet. Der Alkohol sollte mindestens zwei Hydroxygruppen enthalten, da durch mehrfach ungesättigte Verbindungen die erwünschte Vernetzungswirkung erreicht wird. Bevorzugt werden mindestens zweifach ungesättigte Verbindungen; es können aber auch einfach ungesättigte, z. B. Ester von einwertigen Alkoholen, im Gemisch enthalten sein. Beispiele für geeignete mehrwertige Alkohole sind Ethylenglykol, Propylenglykol, Butandiol-1,4, Diethylenglykol, Triethylenglykol, Oligopropylenglykole, Trimethylolethan und -propan, Pentaerythrit, Dipentaerythrit, Bisphenol-A-bis-hydroxyethylether. Es sind ferner die niedermolekularen, Urethangruppen enthaltenden Bis-acrylate und Bis-methacrylate geeignet, die durch Umsetzen von 2 mol Hydroxyalkylacrylat oder -methacrylat mit 1 mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Besonders vorteilhaft sind Acrylate und Methacrylate, insbesondere Acrylate, mit hohem Doppelbindungsgehalt. So werden Monomere mit 3 oder mehr ungesättigten Gruppen bevorzugt. Auch sind im allgemeinen Ester, die noch mindestens eine freie Hydroxygruppe enthalten, den vollständig veresterten Verbindungen überlegen. Die Ester des Trimethylolpropans, Trimethylolethans, des Pentaerythrits und Dipentaerythrits werden besonders bevorzugt. Das Monomere ist im allgemeinen in einer Menge von 10 bis 35, vorzugsweise von 15 bis 30 Gew.-%, bezogen auf den Gesamtgehalt an nichtflüchtigen Bestandteilen, in dem Gemisch enthalten.

Das polymere Bindemittel ist in Wasser unlöslich und in wäßrig-alkalischen Lösungen löslich. Hierzu eignen sich Polymere mit seitenständigen Carboxyl- oder Carbonsäureanhydridgruppen.

Bevorzugt werden durch radikalische Polymerisation herstellbare Vinyl-polymerisate, insbesondere Copolymerisate von $\alpha$, $\beta$-ungesättigten Carbonsäuren, z.B. Crotonsäure, Itaconsäure, Maleinsäure und deren Anhydrid, Acryl- und Alkacrylsäuren. Als Comonomere kommen Vinylester, Vinylether, Vinylaromaten, (Meth)acrylsäureester und -amide und dgl. in Betracht.

Besonders bevorzugt werden Copolymere der Acryl- und Methacrylsäure, die als Comonomere insbesondere Acryl- oder Methacrylsäureester, Styrole, Acryl- oder Methacrylnitril, Acryl- oder Methacrylamid oder Vinylheterocyclen enthalten. Als (Meth)acrylsäureester werden Alkylester mit vorzugsweise 1 bis 10, insbesondere 1 bis 7 Kohlenstoffatomen in der Alkylgruppe eingesetzt. Das Styrol kann ein o-, m- oder p-Vinyltoluol, ein Vinylethylbenzol, das $\alpha$-Methyl- oder $\alpha$-Chlorstyrol, ein o-, m- oder p-Chlorstyrol, ein Vinylanisol oder dgl. sein. Das unsubstituierte Styrol wird im allgemeinen bevorzugt. Der Mengenanteil an Styroleinheiten liegt im Bereich von 30 bis 65, vorzugsweise von 45 bis 60 Gew.-%; der des (Meth)-acrylsäureesters bei 5 bis 40, vorzugsweise zwischen 5 und 25 Gew.-%. Die (Meth)acrylsäureeinheiten sollten in solcher Menge vorliegen, daß die Säurezahl des Polymeren im Bereich von 110 bis 280, vorzugsweise von 125 bis 260 liegt. Der Mengenanteil des Polymeren im Gemisch beträgt im allgemeinen 15 bis 50, vorzugsweise 20 bis 40 Gew.-%.

Als durch Strahlung aktivierbare Polymerisationsinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine; Phenazinderivate, wie 9,10-Dimethylbenz(a)phenazin; Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861, der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxysysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)-4,6-bis-trichlormethyl-s-triazin.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Das erfindungsgemäße Gemisch kann ferner einen teilchenförmigen, im Beschichtungsmittel und Entwickler unlöslichen Füllstoff (f), insbesondere ein mineralisches Pigment enthalten. Als mineralisches Pigment sind Silikate oder Kieselsäuren geeignet. Sie sollten zu einer solchen Teilchengröße vermahlen sein, daß mindestens 80 % der Teilchen einen Durchmesser von 10 $\mu$m oder darunter haben. Dadurch erhält die Lötmaske eine glatte Oberfläche. Diese silikatischen Mineralien enthalten praktisch alle chemisch gebundenes Wasser in Form von OH-Gruppen am Silicium.

Beispielsweise können eingesetzt werden: Kieselerden, Talke, Quarze, Kaoline, Wollastonite, Feldspate, Amphibole, Serpentin, Zeolite, Bimse und Phenolithe. Der $SiO_2$-Gehalt liegt dabei meist oberhalb 60 %. Als Gegenionen, die im Kristallverband enthalten sind, fungieren vorteilhaft Aluminium, Erdalkali- und Alkalimetalle. Der Mengenanteil des Pigments beträgt allgemein etwa 0 bis 50, vorzugsweise 20 bis 40 Gew.-%.

Vorzugsweise enthält das Gemisch mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstoppmaske während des Lötens und danach deutlich sichtbar machen. Hierfür geeignete Farbstoffe sind in der DE-A 3 114 931 beschrieben.

Das Gemisch kann gegebenenfalls eine Reihe weiterer üblicher Zusätze enthalten, z. B. Inhibitoren zur Verhinderung der thermischen Polymerisation der Monomeren, Wasserstoffdonatoren, Lichtempfindlichkeitsregler, Pigmente, Weichmacher und Thixotropiermittel oder organische Polymere, wie Polyacrylamide. Thixotropiermittel sind z. B. beim Antrag durch Vorhanggießen von Vorteil.

Das erfindungsgemäße Gemisch ist in der verarbeitungsfertigen Form nur begrenzt haltbar; daher werden die Einzelkomponenten zweckmäßig in mindestens zwei Gebinden - "Zweikomponentenlack" - getrennt aufbewahrt. Normalerweise wird so verfahren, daß alle Komponenten, mit Ausnahme der Epoxidverbindung, in einer Hauptmischung vorliegen, der kurz vor der Verarbeitung das Epoxid beigemischt wird. Man kann aber auch z. B. den Härtungsinitiator als getrennte Komponente halten. Auch Farbstoffe, mineralischer Feststoff und andere Zusatzstoffe können in getrennten Mischkomponenten vorliegen, so daß gegebenenfalls auch ein Dreikomponentensystem rezepturiert werden kann. Wichtig ist, daß die Teilgemische vor dem Mischprozeß eine hinreichend lange Haltbarkeit (ca. 6 bis 12 Monate) besitzen.

Die Verarbeitung des erfindungsgemäßen Gemischs erfolgt in bekannter Weise, z. B. im Siebantrag. Das gelöste bzw. dispergierte Gemisch wird z. B. durch ein in einem Metallrahmen gespanntes Siebgewebe von 37 bis 55 Maschen je cm mit einer Rakel auf das Leiterplattenobjekt aufgebracht. Eine andere Möglichkeit ist die Vorhangbeschichtung. Mit Hilfe einer handelsüblichen Vorhanggießmaschine wird ein kontinuierlich vertikal laufender Flüssigkeitsfilm erzeugt. Mittels eines Förderbandes wird die Leiterplatte unter diesem Film durchgeführt und damit beschichtet. Das Gemisch kann schließlich auch über eine Sprühbeschichtung, vorzugsweise eine elektrostatische Sprühbeschichtung, aufgebracht werden. In einer geschlossenen Kabine wird die Lösung an einem Sprühkopf in feinste Tröpfchen zerteilt, diese durch Hochspannung elektrostatisch aufgeladen und auf der Leiterplatte abgeschieden. Auch im Tauchziehverfahren und durch Walzenantrag lassen sich die Mischungen verarbeiten.

Die nach einem der geschilderten Verfahren verarbeiteten Beschichtungsgemische werden durch Trocknen im Umlufttrockenschrank und bzw. oder unter einem IR-Trockner vom Lösemittel befreit. Die so beschichtete Leiterplatte wird dann durch eine Vorlage belichtet, die die Teile der Platte vor der Bestrahlung schützt, die für den Lötvorgang freibleiben müssen.

Als aktinische Strahlung, gegenüber der das erfindungsgemäße Gemisch empfindlich ist, kommt jede elektromagnetische Strahlung in Betracht, deren Energie zur Anregung eines geeigneten Polymerisationsinitiators ausreicht. Geeignet ist insbesondere sichtbares und ultraviolettes Licht, Röntgen-, $\gamma$- und Elektronenstrahlung. Auch Laserstrahlung im sichtbaren und UV-Bereich kann verwendet werden. Bevorzugt wird kurzwelliges sichtbares und nahes UV-Licht.

Entwickelt werden die Schichten in bekannter Weise. Als Entwickler sind wäßrig-alkalische Lösungen, z. B. von Alkaliphosphaten, -carbonaten oder -silikaten, geeignet, denen gegebenenfalls kleine Mengen, z. B. bis zu 10 Gew.-%, an mit Wasser mischbaren organischen Lösemitteln oder Netzmitteln zugesetzt werden können.

Fertig entwickelte Lötmasken werden vor dem Lötprozeß einer Temperaturbehandlung unterzogen. Dabei reagieren z. B. die Carboxylgruppen des Bindemittels mit dem mehrfunktionellen Epoxid zu einem interpenetrierenden Netzwerk. Integrierender Bestandteil dieses Netzwerkes ist ggf. auch der mineralische Feststoff.

Insgesamt werden durch die thermische Nachbehandlung die guten mechanischen, thermischen und chemischen Eigenschaften der Lötstoppmasken bewirkt. Diese thermische Behandlung erfolgt im allgemeinen zwischen 80 °C und 180 °C bei ungefähren Behandlungszeiten von 10 bis 90 Minuten. Die lötbereite Platte wird anschließend verzinnt und kann dann mit elektronischen Bauelementen in bekannter Weise bestückt werden.

Die Leitungsseite der Platte wird anschließend üblicherweise mit einem passenden, handelsüblichen Flußmittel behandelt und z. B. über eine handelsübliche Wellenlötmaschine der Wellenlötung unterworfen. Als Lötmittel dienen bekannte eutektische Gemische, die Löttemperaturen von etwa 230 bis 290 °C gestatten. Ein bekanntes Gemisch enthält beispielsweise 63 Gew.-% Zinn und 37 Gew.-% Blei. Besonders bei Verfahren, bei denen doppelseitige, durchkontaktierte Leiterplatten durch Eintauchen in flüssige Metallbäder gelötet werden, lassen sich die erfindungsgemäß hergestellten Lötstoppmasken mit Erfolg einsetzen.

Die erfindungsgemäßen Gemische ergeben Lötstoppresistschichten, die sich durch hohe Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 $\mu$m einwandfrei und vollständig mit wäßrig-alkalischen Lösungen entwickeln. Gegenüber sonst gleicher, aber unter Verwendung von aromatischen Epoxiden und solchen mit Glycidylgruppen hergestellten Gemischen haben die erfindungsgemäßen Gemische eine höhe Lagerfähigkeit in Lösung und als feste Schicht auf einer strukturierten Leiterplatte.

Die belichteten und entwickelten Schichten lassen sich ohne übermäßige Beeintrachtigung der Flexibilität der Maske oder ihrer Haftung auf der Unterlage und ohne Veränderung der Lage und Dimensionen der durch Entwicklung freigelegten Bereiche thermisch härten. Die gehärteten Masken sind gegenüber atmosphärischen, thermischen und chemischen Einflüssen über längere Zeiträume beständig. Nach dem Belichten der Resistschicht wird ein kontrastreiches Bild in der Schicht erhalten. Die aus den erfindungsgemäßen Gemischen erhaltenen Lötstoppmasken eignen sich in besonderem Maße dazu, empfindliche elektronische Leiterstrukturen vor atmosphärischen Angriffen wirksam und dauerhaft zu schützen.

Die folgenden Beispiele erläutern einzelne Ausführungsformen des erfindungsgemäßen Gemisches. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu ml.

Beispiel 1 (Vergleichsbeispiel)

Herstellung einer verarbeitungsfertigen Lötstoppmaske

a) 280 Gt Styrol, 140 Gt Methacrylsäure, 80 Gt n-Hexylmethacrylat und 11,5 Gt 2,2-Azo-bis-isobuttersäurenitril wurden unter Rühren in 450 Gt 3-Methoxy-butanol-1 gelöst. 1/3 dieser Lösung wurde in einem Rundkolben unter Rühren und Hindurchleiten von Stickstoff auf 90 °C erwärmt. Die einsetzende exotherme Polymerisation wurde durch äußere Kühlung bei 90 °C bis maximal 100 °C gehalten. Nach Abklingen der Hauptreaktion wurden die zurückbehaltenen 2/3 der Lösung innerhalb 1 1/2 Stunden gleichmäßig zudosiert und anschließend die Reaktionslösung noch 12 bis 14 Stunden bei 90 °C gehalten. Die Polymerlösung war nach Abkühlen auf Zimmertemperatur gebrauchsfertig. Die reduzierte spezifische Viskosität des Produkts betrug 0,185 dl/g (gemessen an einer 1 %igen Lösung in Dimethylformamid bei 25 °C).

b) In einem zylindrischen Gefäß wurden in 123,9 Gt 3-Methoxy-butanol-1 112,5 Gt Pentaerythrit-triacrylat,

128,9 Gt Trimethylolpropan-triacrylat,

27,5 Gt 9-Phenylacridin,

12,4 Gt Neozapongrün,

1,2 Gt eines blauen Azofarbstoffs, erhalten durch Kuppeln von 2,4-Dinitro-6-chlor-benzol-diazoniumsalz mit 2-Methoxy-5-acetylamino-N,N-diethylanilin und
2,5 Gt Triethylendiamin

mit einem hochtourigen Schnellrührer in Lösung gebracht. Dann wurden im Verlauf von 30 Minuten 396,7 Gt eines silikatischen Pigments, das ein natürliches Agglomerat von korpuskularem Quarz und laminarem Kaolinit ist, in die gerührte Lösung eingestreut. Es enthält über 80 % $SiO_2$ und ca. 11 % $Al_2O_3$; ca. 90 Gew.-% der Teilchen haben eine Korngröße unterhalb 5 $\mu$m (Sillitin). Dieser Suspension wurden anschließend 694,2 Gt der unter a) beschriebenen Polymerlösung zugesetzt. Der nun mit allen Komponenten versehene Ansatz wurde mit Hilfe des Mischers gut homogenisiert (1.200 U/min), wobei darauf geachtet wurde, daß die Temperatur des Ansatzes nicht über 50 bis 55 °C anstieg.

Der viskose Lack wurde zur weiteren Homogenisierung in einer Glaskugelmühle vermahlen und dann durch ein 160 $\mu$m V2A-Gewebe-Druckfilter filtriert und abgefüllt. Diese Mischung wurde, soweit erforderlich, mit Methoxybutanol auf einen Feststoffgehalt von 68,6 Gew.-% verdünnt und im Folgenden als Komponente A bezeichnet.

c) In einem zylindrischen Gefäß wurden 260 Gt eines Epoxydharzes aus Bisphenol A und Epichlorhydrin mit dem Epoxid-Äquivalentgewicht 190 bis 200 in 148 Gt 3-Methoxybutanol mittels eines Ankerrührers gelöst. Nach 15 Minuten Rührzeit lag eine klare Lösung mit 63 % Feststoffgehalt vor. Diese Lösung wurde im Folgenden als Komponente B bezeichnet.

d) 100 Gt der Komponente A wurden mit 22,3 Gt der Komponente B mit einem passenden Rührer intensiv gemischt. Damit war die Lötstopplösung zum Gebrauch, also zum Antrag auf eine Leiterplatte nach einem der oben erwähnten Verfahren, fertig. Der Feststoffgehalt betrug 67,5 %.

e) Eine 24 x 36 cm große Platte aus Epoxidharz-Glasgewebe mit einem beidseitig aufgebrachten Schaltbild aus 0,2 bis 1,5 mm breiten und 50 bis 90 $\mu$m dicken Kupferbahnen und durchkontaktierten Bohrungen wurde mit der unter d) beschriebenen Lösung mittels einer halbautomatischen Siebdruckmaschine (Alfra-Plan 50/70) vollflächig beschichtet. Zur Lackübertragung wurde ein vollflächig offenes Polyestersieb mit 43 Maschen je cm verwendet; die Gummirakel mit einer Härte von 70 Shore war an der Druckkante leicht abgerundet, und der Antragswinkel betrug 15°. Auf diese Weise ließen sich blasen- und farbschattenfreie Beschichtungen mit einer Flankenabdeckung von 15 bis 20 $\mu$m erzielen. Die so beschichtete Leiterplatte wurde 5 Minuten bei Raumtemperatur belassen und anschließend 7 Minuten in einem Umlufttrockenschrank bei 80 °C getrocknet. Nach dem Abkühlen auf Raumtemperatur wurde die beschichtete Leiterplatte durch eine Filmvorlage bildmäßig belichtet.

Entwickelt wurde in einer Durchlaufsprühanlage mit 1,3 %iger wäßriger Sodalösung bei 30 °C mit 1,2 bar Sprühdruck. Die Entwicklungszeit betrug 90 s; die unbelichteten Schichtbereiche waren bereits nach etwa 2/3 der Entwicklerstrecke frei entwickelt.

Nach Waschen mit Wasser wurde die entwickelte Platte in einem Warmluftdurchlauftrockner getrocknet und anschließend in einem Umlufttrockenofen 1 Stunde bei 150 °C getempert. Die nun vollständig ausgehärtete Platine wurde wellengelötet, eine zweite Platine, die in gleicher Weise hergestellt worden war, wurde heißverzinnt.

Das Löten wurde auf einer Wellenlötmaschine durchgeführt. Dazu wurde die Platte über einen vorgeschalteten Schaumfluxer (Alphagrillo[R] RF 12A) geführt, vorgetrocknet und über das aus eutektischer Blei/Zinnlegierung bestehende flüssige Lot gefahren. Die Geschwindigkeit betrug 1 m je Minute, die Lottemperatur 265 °C.

Das Lötergebnis nach einmaligem Wellendurchgang war sehr gut. Um Unterschiede deutlicher werden zu lassen, wurde der Vorgang noch dreimal wiederholt. Die Ergebnisse zeigt Tabelle 1.

Die in Tabelle 1 angegebenen Parameter haben die folgende Bedeutung:

**Elektrolytische Korrosion (E-Korrosion):**

Die Bestimmung entspricht der in der Leiterplattentechnik allgemein üblichen und anerkannten Vorschrift SN 57030, die auf die Siemens AG zurückgeht. Mehrzweck-Testplatten gemäß IPC B-25 wurden 24 Tage bei 40 °C und 92 % rel. Feuchte gelagert, wobei an jeweils zwei Parallel verlaufende Leiterbahnen 100 V Gleichspannung angelegt wurden. Die Korrosion wurde visuell beurteilt und das Ergebnis wie folgt bewertet:

|       |             |
|-------|-------------|
| + +   | sehr gut    |
| +     | gut         |
| 0     | ausreichend |

**Schichtkosmetik:**

Es wird die mit bloßem Auge sichtbare Gleichmäßigkeit der Schicht hinsichtlich Struktur und Farbton bewertet.

**Topfzeit:**

Es wird die Zeit der Lagerung der fertigen Beschichtungslösung bei Raumtemperatur angegeben, nach der noch eine lichtempfindliche Schicht erhalten wird, die sich ohne Probleme verarbeiten läßt. Als Endpunkt wird die Zeit angenommen, nach der eine Schicht erhalten wird, die zur Entwicklung die doppelte Zeit wie eine aus frischer Lösung hergestellte Schicht benötigt.

**Trocknungsfenster:**

Es wird der Parameterbereich von Trocknungstemperatur und Trocknungsdauer ermittelt, innerhalb dessen ein brauchbares Ergebnis erhalten wird. Dabei wird zur ausreichenden Trocknung eine Temperatur von 50 °C und eine Mindesttrockenzeit von 6 bis 10 Minuten in Abhängigkeit von der Trockentemperatur festgesetzt. Eine übermäßige Trocknung führt zu einem Produkt, das sich nicht mehr einwandfrei verarbeiten, insbesondere entwickeln läßt. Die Obergrenze wird durch eine Kurve beschrieben, die von 6 Minuten bei 100 °C bis 120 Minuten bei 50 °C etwa exponentiell abfällt. Die Fläche, die durch diese Kurve sowie die Untergrenzen 50 °C und 10 Minuten umschrieben wird, wird als Trocknungsfenster bezeichnet und stellt die Bedingungen für das Vergleichsbeispiel 1 dar. Durch eine Verschiebung der Exponentialkurve nach schärferen oder milderen Bedingungen für die maximal zulässige Trocknung wird die Fensterfläche verändert. Für jedes Beispiel wird diese Fläche in %, bezogen auf 100 % für Vergleichsbeispiel 1 angegeben. Ein höherer Prozentwert bedeutet somit eine größere Verarbeitungsbreite.

**Lagerfähigkeit:**

Es wird die Lagerfähigkeit einer mit der getrockneten unbelichteten Lötstoppschicht beschichteten Leiterplatte bei Raumtemperatur in Stunden angegeben. Auch hier wird als Endpunkt das Erreichen der doppelten Entwicklungszeit festgesetzt.

**Entwicklungszeit:**

Es wird die Zeit in Sekunden angegeben, die zur schleierfreien Entwicklung einer größeren unbelichteten Fläche (break point) mit einer 1,3 %igen Sodalösung bei 28 °C benötigt wird.

**Lichtempfindlichkeit:**

Es wird die Anzahl der sichtbar gehärteten Keilstufen eines Standard-Stufenkeils (Lichtintensitätsfaktor je Stufe V2) bei 300 mJ/cm$^2$ aus einer Fe-dotierten Quecksilberdampflampe angegeben.

**Unterwanderung an der Steckerleisten:**

Es wird die Zahl der Steckerleisten, d.h. der von den Anschlußstellen ausgehenden Kupferleisten, an denen die Lötstoppmaske von Blei-Zinn-Lot unterwandert ist, in % der Gesamtzahl angegeben.

**Abhebungen der Lötstoppmaske von den Leiterbahnen:**

Es wird der Flächenanteil der Leiterbahnen in % angegeben, an dem die Lötmaske blasig oder anderweitig sichtbar vom Kupfer abgehoben ist.

**Abziehtest mit Klebeband:**

Zur Prüfung der Haftung der Lötmaske auf den Leiterbahnen an den nicht sichtbar abgehobenen Stellen wird nach dem Löten ein Haftklebestreifen auf die abgekühlte Lötmaske gepreßt und im Winkel von 90° ruckartig abgezogen.

f) Wird der unter d) beschriebene, für den Siebantrag direkt verwendbare Lack für ein anderes Antragsverfahren verwendet, so ist der Feststoffgehalt von 67,5 % zu hoch. Wird die Maske durch einen vertikal fallenden Vorhang aus dem Längsspalt einer Vorhanggießmaschine auf die Leiterplatte angetragen, muß der Feststoff durch Verdünnen mit Methoxybutanol auf ca. 58 Gew.-% gesenkt werden. Ähnliche Konzentrationen sind erforderlich, wenn die Maske im Hochspannungsfeld mittels eines rotierenden Sprühkopfes auf die Leiterplatte gesprüht wird. Auch diese Techniken führen zu einer sehr guten Leiterbahnumhüllung durch die Maske, die die Platte porenfrei und in gleichmäßiger Stärke abdeckt. Die Verarbeitung gemäß e) führt zu demselben guten Ergebnis.

Beispiele 2 bis 12

Die Beispiele 4, 7, 9 und 11 sind Vergleichsbeispiele.

In allen Beispielen wurde mit der gleichen Rezeptur wie in Beispiel 1 gearbeitet, jedoch wurde das dort verwendete Epoxyharz in den erfindungsgemäßen Beispielen durch jeweils die angegebene Menge einer der folgenden Epoxyverbindungen ersetzt:

1 Bis(3,4-epoxy-cyclohexylmethyl)adipat
2 3,4-Epoxy-cyclohexylmethyl-3,4-epoxy-cyclohexancarbonsäureester
3 3,4-Epoxy-cyclohexyl-oxiran
4 3-(3,4-Epoxy-cyclohexyl)-8,9-epoxy-2,4-dioxaspiro[5.5]undecan

Im einzelnen wurden in den Beispielen 2 bis 12 die folgenden Epoxyharze anstelle des Epoxyharzes aus Bisphenol A und Epichlorhydrin eingesetzt:

Beispiel 2

Wie in Beispiel 1, aber mit der Epoxyverbindung 1; Epoxy-Äquivalentgewicht 187.

Beispiel 3

Wie Beispiel 1, aber mit 186 Gt der Epoxyverbindung 2 in 214 Gt 1-Methoxy-propyl-2-acetat; Epoxy-Äquivalentgewicht 135.

Beispiel 4(V)

Wie Beispiel 1, aber mit einem Novolak-glycidylether in gleicher Menge wie die dort verwendete Epoxyverbindung; Epoxy-Äquivalentgewicht 195.

Beispiel 5

Wie Beispiel 1, aber mit 192 Gt der Epoxyverbindung 3 in 208 Gt Methoxypropanol; Epoxy-Äquivalentgewicht 70.

Beispiel 6

Wie Beispiel 1, aber mit 152 Gt der Epoxyverbindung 4 in 248 Gt Methoxybutanol; Epoxy-Äquivalentgewicht 133.

Beispiel 7(V)

Wie Beispiel 1, aber mit einem Gemisch aus Pentaerythrittriacrylat und Polypropylenglykoldiacrylat ($M_W$ = 420) im Gewichtsverhältnis 1:1 anstelle des dort verwendeten Monomerengemisches.

Beispiel 8

Wie Beispiel 7, aber mit 186 Gt der Epoxyverbindung 2 in 214 Gt 1-Methoxy-propyl-2-acetat; Epoxy-Äquivalentgewicht 135.

Beispiel 9(V)

Wie Beispiel 1, aber mit einem Gemisch von Pentaerythrittriacrylat und Polybutan-1,4-diol-diacrylat ($M_W$ = 400) im Gewichtsverhältnis 15 : 85 anstelle des dort verwendeten Monomerengemisches.

Beispiel 10

Wie Beispiel 9, aber mit 186 Gt der Epoxyverbindung 2 in 214 Gt 1-Methoxy-propyl-2-acetat; Epoxy-Äquivalentgewicht 135.

Beispiel 11(V)

Wie Beispiel 1, aber mit einem Copolymeren aus 20 Gt Acrylsäure, 10 Gt Styrol und 70 Gt Methylmethacrylat anstelle des dort verwendeten copolymeren aus Styrol, Methacrylsäure und n-Hexylmethacrylat.

Beispiel 12

Wie Beispiel 11, aber mit 186 Gt der Epoxyverbindung 2 in 214 Gt 1-Methoxy-propyl-2-acetat; Epoxy-Äquivalentgewicht 135.

TABELLE 1

| Beispiel Nr. | 1(V) | 2 | 3 | 4(V) | 5 | 6 | 7(V) | 8 | 9(V) | 10 | 11(V) | 12 |
|---|---|---|---|---|---|---|---|---|---|---|---|---|
| Schichtkosmetik | gut | gut | gut | fleckig | gut | gut | gut | gut | gut | gut | gut | gut |
| Klebrigkeit | nicht | gering | nicht | gering | gering | gering | nicht | nicht | nicht | nicht | gering | gering |
| Topfzeit (Tage) | 7 | 10 | >10 | 6 | 7 | 9 | 7 | >10 | 7 | >10 | 7 | 9 |
| Trocknungsfenster (%) | 100 | 250 | 250 | 80 | 150 | 150 | 80 | 125 | 90 | 150 | 100 | 150 |
| Lagerfähigkeit (h) | 48 | 100 | 100 | 48 | 72 | 72 | 48 | 100 | 48 | 100 | 48 | 72 |
| Entwicklungszeit (s) | 60 | 40 | 20 | 90 | 20 | 30 | 75 | 50 | 60 | 45 | 65 | 40 |
| Lichtempfindlichkeit | 3 | 4 | 6,5 | 3 | 5 | 5 | 4 | 8 | 7 | 8,5 | 4 | 7 |
| Gradation | flach | mittel | mittel | flach | mittel | mittel | flach | mittel | flach | mittel | flach | mittel |
| E-Korrosion | + | ++ | ++ | 0 | +, | ++ | + | ++ | + | + | 0 | + |
| Unterwanderung an den Steckerleisten % | 60-75 | 0 | 0 | 50 | 15 | 0 | 50 | 10 | 40 | 0 | 40 | 10 |
| Abhebung der Lötmaske (%) | 30-50 | 0 | 0 | 30 | 5 | 0 | 30 | 5 | 30 | 0 | 30 | 5 |
| Abziehtest | starker Abriß | kein Abriß | kein Abriß | deutl. Abriß | kein Abriß | kein Abriß | starker Abriß | kein Abriß | deutl. Abriß | kein Abriß | kein Abriß | kein Abriß |

**Patentansprüche**

1. Durch Strahlung polymerisierbares Gemisch, enthaltend

a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches, Carboxylgruppen enthaltendes polymeres Bindemittel,
c) einen durch Strahlung aktivierbaren Polymerisationsinitiator oder eine Polymerisationsinitiatorkombination und
d) eine Verbindung mit mindestens zwei Epoxygruppen,
dadurch gekennzeichnet, daß die Epoxyverbindung eine cycloaliphatische Epoxyverbindung ist.

2. Durch Strahlung polymerisierbares Gemisch nach Anspruch 1, dadurch gekennzeichnet, daß die Epoxyverbindung (d) einen epoxydierten Cycloalkenring mit 5 bis 7 Ringgliedern oder einen durch eine epoxydierte Alkenylgruppe substituierten Cycloalkanring mit 5 bis 7 Ringgliedern enthält.

3. Durch Strahlung polymerisierbares Gemisch nach Anspruch 1, dadurch gekennzeichnet, daß es zusätzlich einen durch Wärme aktivierbaren Vernetzungsinitiator (e) für Epoxyverbindungen enthält.

4. Durch Strahlung polymerisierbares Gemisch nach Anspruch 1, dadurch gekennzeichnet, daß es zusätzlich ein feinteiliges mineralisches Pigment (f) enthält.

5. Durch Strahlung polymerisierbares Gemisch nach Anspruch 1, dadurch gekennzeichnet, daß die Verbindung (a) mit mindestens einer ethylenisch ungesättigten Gruppe ein Ester der Acryl- oder Methacrylsäure ist.

6. Durch Strahlung polymerisierbares Gemisch nach Anspruch 1, dadurch gekennzeichnet, daß das Carboxylgruppen enthaltende Bindemittel (b) ein Mischpolymerisat der Acryl- oder Methacrylsäure ist.

7. Durch Strahlung polymerisierbares Gemisch nach Anspruch 1, dadurch gekennzeichnet, daß es
10 - 35 Gew.-%     an Verbindung (a) mit ethylenisch ungesättigten Gruppen,
15 - 50 Gew.-%     Carboxylgruppen enthaltendes Bindemittel (b),
0,01 - 10 Gew.-%     Polymerisationsinitiator (c) und
10 - 30 Gew.-%     an Epoxyverbindung (d)
enthält.

8. Verfahren zur Herstellung einer Lötstoppmaske, dadurch gekennzeichnet, daß man eine Lösung oder Dispersion eines Gemisches gemäß einem der Ansprüche 1 bis 7 auf die Oberfläche einer strukturierten Leiterplatte aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Maske auf erhöhte Temperatur erwärmt.